(19) Europäisches Patentamt

European Patent Office

Office européen des brevets

(11) **EP 1 048 956 A2**

(12) **EUROPEAN PATENT APPLICATION**

(43) Date of publication:
**02.11.2000 Bulletin 2000/44**

(51) Int. Cl.[7]: **G01R 31/28**

(21) Application number: **00303349.5**

(22) Date of filing: **20.04.2000**

(84) Designated Contracting States:
**AT BE CH CY DE DK ES FI FR GB GR IE IT LI LU MC NL PT SE**
Designated Extension States:
**AL LT LV MK RO SI**

(30) Priority: **28.04.1999 US 131474 P**
**11.04.2000 US**

(71) Applicant:
**LUCENT TECHNOLOGIES INC.**
**Murray Hill, New Jersey 07974-0636 (US)**

(72) Inventors:
- **Cruceta, Sergio**
  **Mostoles (ES)**
- **Garcia, Alfredo**
  **Madrid (ES)**
- **Merino, Miguel Angel**
  **Madrid (ES)**

(74) Representative:
**Watts, Christopher Malcolm Kelway, Dr. et al**
**Lucent Technologies (UK) Ltd,**
**5 Mornington Road**
**Woodford Green Essex, IG8 0TU (GB)**

(54) **Method and apparatus for analizing a semiconductor wafer manufacturing process**

(57) A method for processing semiconductor wafers includes performing process steps to make at least one wafer to include a plurality of devices thereon, with each device including an array of memory cells. Each array of memory cells are inspected to detect defects. Failed memory cells are predicted based upon detected defects, and a yield of the wafer is predicted based upon the predicted failed memory cells. The predicted yield is compared to a threshold to determine if corrective action is needed. By examining each array of memory cells for defects during the process steps, and determining the probability of each defect resulting in a failed memory cell, the yield of the wafer can be determined accurately without having to analyze areas outside of the array of memory cells.

*FIG. 1*

EP 1 048 956 A2

## Description

### Field of the Invention

The present invention relates to the field of semiconductor wafer processing, and, more particularly, to a method and apparatus for analyzing a semiconductor wafer process for increasing the yield of semiconductor wafers.

### Background of the Invention

Semiconductor wafer processing involves complex process steps to form devices on the surface of a silicon wafer. A goal of semiconductor wafer processing is to attain a high yield. Yield is a percentage which indicates the amount of good devices in a wafer divided by the total number of devices in that wafer.

A number of discrete process steps are required to form a device including an array of memory cells from raw semiconductor material. The starting substrate is usually a slice of single crystal silicon referred to as the wafer. A plurality of devices are fabricated together in batches of wafers called lots or runs. The individual wafers in a lot may go through individual process steps one at a time or as a batch. At the completion of the process steps, the devices are tested to determine circuit functionality.

A method of analyzing a failure in a device comprising an array of memory cells is done by testing an electrical property of each memory cell. A tester is used to test each memory cell, and the resultant data is provided in a coordinate space of rows (X) and columns (Y) to produce a failure pattern. This pattern is generally called a bitmap failure, and corresponds to the cause of the failures. The bitmap may also be referred to as a map of failed memory cells. A cause of the failure is estimated using the bitmap.

The cause of the failure obtained with the bitmap is an estimation of the failure and an electrical abnormality at that position, i.e., an estimation of what failure is happening at which position. Failures may be a result of particle contamination, leakages, opens or shorts resulting during an individual process step.

To correct the failure, the cause of the failure in the process step must be clarified. One such approach is disclosed in U.S. Patent No. 5,844,850 to Tsutsui et al. A physical inspection for defects is performed at a surface of each memory device using a defect inspection device for each process step in the production line. An electrical property of the memory cells in each array of memory cells are also tested by a tester to produce the bitmap. The result of the physical inspection is collated with the bitmap, thereby allowing estimation as to whether a failure is caused by foreign materials, defects and the like during the manufacturing process.

Unfortunately, the cause of a failure is not always located at the position of the failure found by the tester, and there are many cases where the cause of a failure is located at a position other than the position of the failure. Moreover, not all the foreign materials and defects produced during the manufacturing process cause a failure, and whether foreign materials or defects cause a failure or not depends on the position, size and the like thereof. Therefore, there is a need to improve the way defects are analyzed during a semiconductor wafer process.

### Summary of the Invention

In view of the foregoing background, it is therefore an object of the present invention to analyze defects detected during the process steps of a device comprising an array of memory cells so that corrective action can be taken for increasing wafer yield

This and other objects, features and advantages in accordance with the present invention are provided by a method for processing semiconductor wafers comprising the step of performing process steps to make at least one wafer comprising a plurality of devices with each device comprising an array of memory cells. Each array of memory cells are preferably inspected to detect defects. Failed memory cells are preferably predicted based upon detected defects, and a yield of the wafer is preferably predicted based upon the predicted failed memory cells. The predicted yield is preferably compared to a threshold to determine if corrective action is needed.

In other words, yield prediction of the wafer being processed is preferably done in two steps. First, the probability of a detected defect resulting in a failed memory cell is preferably predicted. Second, this predicted probability is preferably used to predict the yield of the wafer being processed. Accurately predicting the probability of a detected defect resulting in a failed memory cell is necessary for accurately predicting the yield of the wafer.

By examining each array of memory cells for defects during the process steps, and determining the probability of each defect resulting in a failed memory cell, the yield of the wafer can be determined accurately without having to analyze areas outside of the array of memory cells.

The step of predicting failed memory cells preferably comprises comparing detected defects to a database of mapped defect information. The database of mapped defect information is preferably being based upon a correlation of defects and associated failed memory cells. The method preferably further includes the step of creating the database of mapped defect information. This correlation of data between the defects and failed memory cells provides a relationship between manufacturing processes and failed memory cells in an array of memory cells, which helps to provide faster identification to the process steps contributing to yield losses. This method according to the present invention also improves failure analysis efficiency and accelerates the resolution of yield problems.

Each array of memory cells are preferably formed in successive layers, and wherein inspecting preferably comprises inspecting each layer. The database of mapped defect information is preferably based upon size ranges of detected defects and the associated layer. Predicting failed memory cells preferably comprises determining a detected defect size range of each detected defect in an associated layer, and predicting failed memory cells preferably based upon matching the detected defect size range and associated layer with the database of mapped defect information.

The step of predicting the yield preferably further comprises determining a number of detected defects within each size range and associated layer, and using the predicted failed memory cells and number of detected defects within each size range and associated layer to predict the yield. Each array of memory cells preferably forms a random access memory, which may be part of a stand alone memory device, such as a DRAM or SRAM, or the random access memory may be an embedded memory within a digital signal processor, for example.

Another aspect of the invention relates to an apparatus for wafer yield prediction. The yield prediction apparatus preferably includes a defect inspection device for detecting defects in a wafer comprising a plurality of devices with each device comprising an array of memory cells. The yield prediction apparatus preferably further includes a processor for predicting failed memory cells based upon detected defects, and for predicting a yield of the wafer based upon the predicted failed memory cells so that the predicted yield can be compared to a threshold to determine if corrective action is needed.

The wafer yield prediction apparatus preferably further includes a memory connected to the processor for storing a database of mapped defect information. The database of mapped defect information is preferably based upon a correlation of defects and associated failed memory cells. The processor preferably predicts failed memory cells by comparing detected defects to the database of mapped defect information.

## Brief Description of the Drawings

FIG. 1 is a flowchart illustrating the method for processing semiconductor wafers in accordance with the present invention.
FIG. 2 is a schematic block diagram of a yield prediction apparatus in accordance with the present invention.
FIG. 3 is a flowchart illustrating the defect prediction algorithm in accordance with the present invention.
FIG. 4 is a schematic block diagram of a correlation device for defining a database of mapped defect information to be used in accordance with the present invention.
FIG. 5 is a flowchart illustrating the yield prediction algorithm in accordance with the present invention.

## Detailed Description of the Preferred Embodiments

The present invention will now be described more fully hereinafter with reference to the accompanying drawings, in which preferred embodiments of the invention are shown. This invention may, however, be embodied in many different forms and should not be construed as limited to the embodiments set forth herein. Rather, these embodiments are provided so that this disclosure will be thorough and complete, and will fully convey the scope of the invention to those skilled in the art. Like numbers refer to like elements throughout.

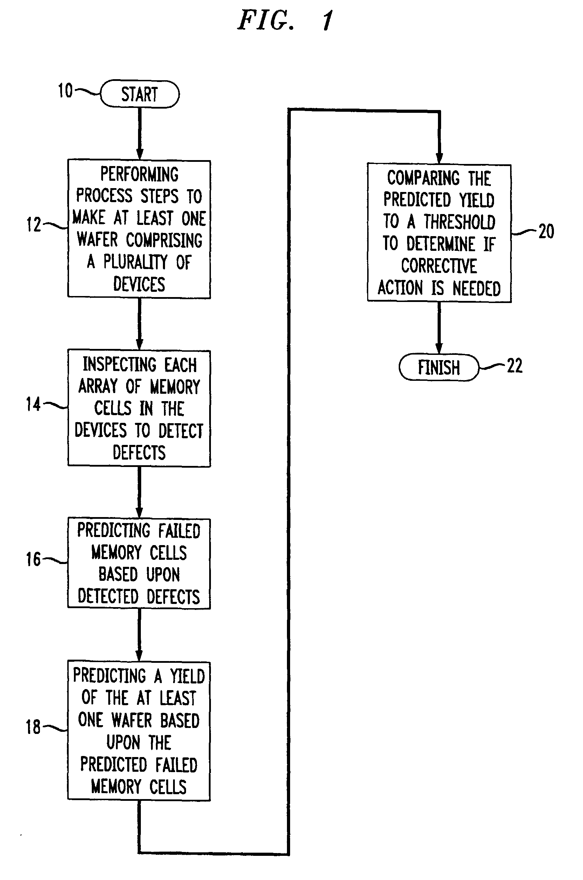

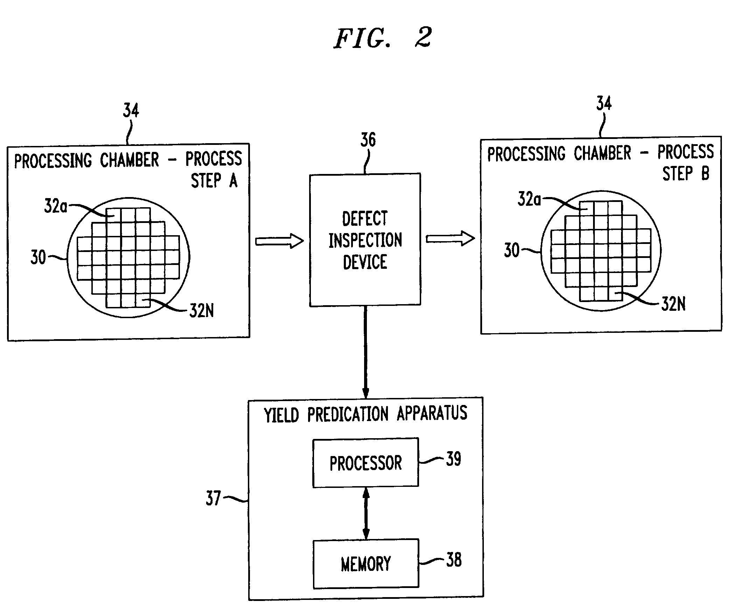

A method for processing semiconductor wafers in accordance with the present invention is now described with reference to FIGS. 1-5. From the start (Block **10**) of the semiconductor manufacturing process, process steps are performed at Block **12** to make at least one wafer **30** comprising a plurality of devices **32a-32n** (FIG. 2). Each device, generally represented by reference **32**, comprises an array of memory cells. The array of memory cells are arranged in a matrix of rows and columns to define a random access memory. The random access memory may be part of a DRAM or SRAM, as readily appreciated by one skilled in the art. Moreover, the random access memory may be embedded in the device, with the device being a digital signal processor (DSP), for example. The process steps are performed in a processing chamber **34**, as best shown in FIG. 2.

A production flow of the wafer **30** includes process steps A and B being formed in the processing chamber **34**, with a defect inspection device **36** being used between the process steps for inspecting the surface of each device **32**. Process step A may be used to form a metal layer for each device **32**, whereas process step B may be used to form a dielectric layer over the metal layer, for example. The defect inspection device **36** optically inspects the external appearance of the array of memory cells between the process steps A and B for particle contamination, opens, shots, and the like that may have been introduced as a result of process step A. For example, process step A may include defective photolithography or etching.

The x-y coordinates for each detected defect are stored in a memory **38**. This memory **38** is connected to a processor **39**, which may be part of a wafer yield prediction apparatus **39**. The wafer yield prediction apparatus **39** will be described in greater detail below. Failed memory cells are predicted at Block **16** (FIG. 1) based upon the detected defects, and a yield of the wafer **30** based upon the predicted failed memory cells is predicted at Block **18** using the wafer yield prediction apparatus **37**.

The predicted yield is compared to a threshold at Block **20** to determine if corrective action is needed. In other words, the yield prediction is done in two steps. First, the probability of a detected defect resulting in a failed memory cell is predicted. Second, this predicted probability is used to predict the yield of the wafer **30** being processed.

Accurately predicting the probability of a detected defect resulting in a failed memory cell is necessary for accurately predicting the yield of the wafer **30**. A comparison between a standard prediction algorithm and the disclosed prediction algorithm according to the present invention for predicting the probability of a detected defect resulting in a failed memory cell will now be discussed. A first noted distinction is that the standard prediction algorithm uses information from all the devices (pass or fail) on the wafer, whereas the disclosed prediction algorithm uses information from the devices that pass and information only from the failed memory cells. In other words, there may be many other failures in each device in addition to failed memory cells, e.g., core logic failures, but they are not considered.

A second distinction is that the output of the standard prediction algorithm is directly the number of failed devices **32** on the wafer **30**. In sharp contrast, the output of the disclosed prediction algorithm is directly the number of devices **32** with memory cell failures in the wafer **30**. The yield of the wafer **30** according to the present invention is then predicted using the correlation between memory failures and detected defects.

A third distinction is that the standard prediction algorithm uses information of defects detected in the entire device **32**, whereas the disclosed prediction algorithm is computed using information from defects detected just in the array of memory cells. This distinction is particularly advantageous since there is a direct relationship between failed memory cells and a failed device, as readily appreciated by one skilled in the art.

Yet another distinction is that the probability of a detected defect resulting in a failed memory cell for the standard prediction algorithm is computed for many wafers in several lots to obtain a statistical distribution of the predicted probability. The median or mean of the distribution is used in the calculations in the standard yield prediction algorithm. In the disclosed prediction algorithm, the median or mean and confidence intervals, i.e., defect size ranges, are used in the disclosed yield prediction algorithm. In other words, the yield of a particular wafer according to the present invention is based on more than a single number.

An advantage of the disclosed prediction algorithm is that the probability of a detected defect resulting in a failed memory cell is more accurate since the determination of this probability is made using information provided from a limited portion of the device, i.e., the array of memory cells. There is a statistical relationship between defects detected within the array of memory cells and actual failed memory cells since the memory array area is a regular and dense structure. Consequently, the probability calculated for the memory area is less prone to show dispersions than calculating the probability of the entire device **32** failing. The disclosed prediction algorithm thus provides a more accurate result than the standard prediction algorithm because of the above noted distinctions.

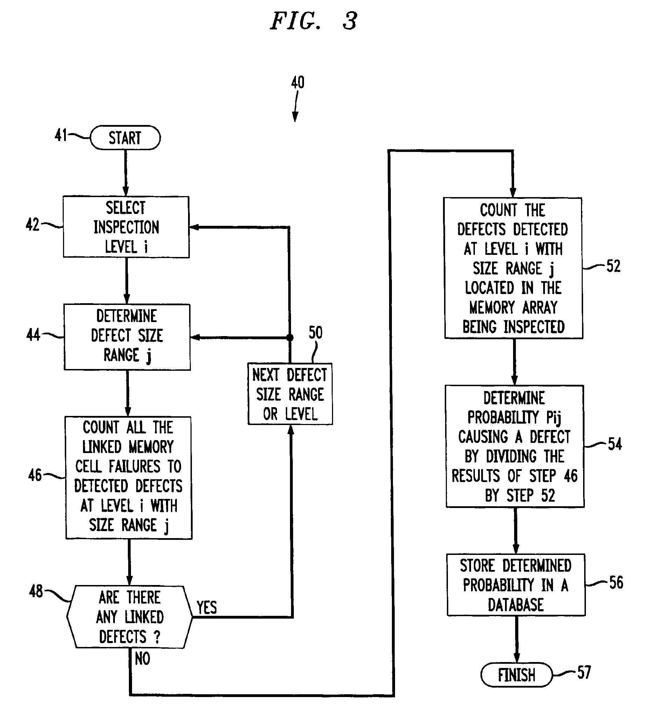

The disclosed defect prediction algorithm **40** for predicting the probability of a detected defect resulting in a failed memory cell will now be discussed in greater detail with reference to the flowchart illustrated in FIG. 3. From the start (Block **41**), an initial inspection level $i$ in process step A, for example, is selected at Block **42**, and a defect size range $j$ of the detected defect is determined at Block **44**. For instance, there may be a predetermined number of discrete intervals between 0 and 100 microns, and a determination is made as to which discrete interval the detected defect belongs within. At Block **46**, all the memory cell failures linked to the detected defect at the selected level $i$ with the selected defect size range $j$ are counted (N_linked-failures).

If there are additional detected defects that are linked to the memory cell failures as determined at Block **48**, steps **42** and/or **44** are repeated for the next defect size range or inspection level as selected at Block **50**. The defects at the initially selected inspection level $i$ with the selected defect size range $j$ are counted (N_defects) at Block **52**. The probability P$ij$ of the detected defect resulting in a failed memory cell is determined at Block **54** by dividing the results of Block **46** (N_linked-failures) by the results of Block **52** (N_defects). The determined probability is stored in a database at Block **56**, and the defect prediction algorithm is finished at Block **57**

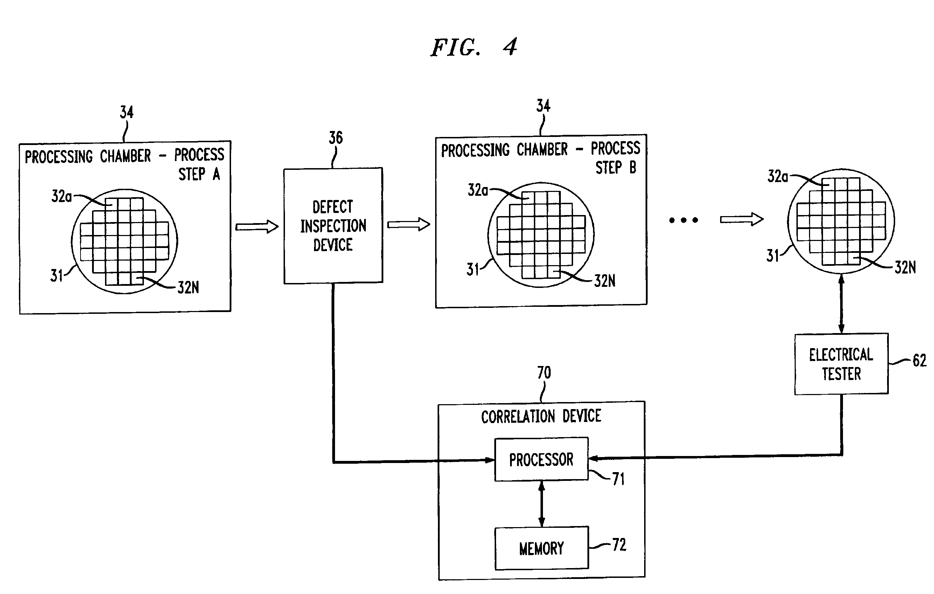

Referring now to FIG. 4, a database of mapped defect information is created. The database is formed by correlating defect information and failed memory cell location obtained from a lot of processed wafers, generally represented by reference **31**. This lot of wafers does not include the wafer **30** processed in FIG. 2. The defect inspection device **36** inspects the surface of the wafers **31** for defects. Electrical tester **62** uses electrical signals to determine which memory cells have failed. The electrical tester **62** is used after the process steps have been completed.

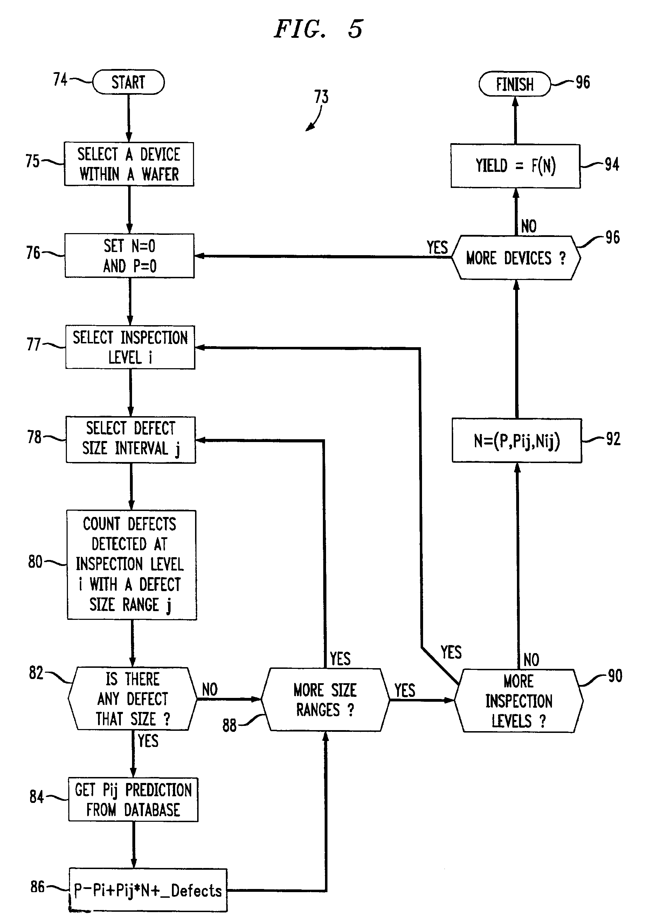

A correlation device **70** includes a processor **71** for receiving the x-y coordinates of the detected defects from the defect inspection device **36**, as well as for receiving the x-y coordinates of the failed memory cells from the electrical tester **62**. The correlated data forming the database of mapped defects is stored in a memory **72** connected to the processor **71**. The yield prediction algorithm **74** for predicting the yield of the wafer **30** based upon the predicted failed memory cells will now be described with reference to FIG. 5. The yield prediction algorithm **74** provides an estimation of the final yield, i.e., after the devices **32** have been completed and tested, based on information obtained during the process steps. This information is related to defects detected at the inspection points strategically placed along the production flow. The yield prediction algorithm **73** may be used to predict the yield on single wafers, as illustrated herein.

The yield prediction algorithm **73** is based on a two step process. First, the probability of a detected defect resulting in a memory cell failure is determined (FIG. 3). Second, this probability is used in the yield prediction algorithm **73**. As illustrated in FIGS. 2 and 4, the manufacturing process is split into several steps. After each of these steps a process inspection may be performed using a defect inspection device **36**. Each inspection provides information about the defects between the current and previous process steps. Therefore, the probability of a device failing can be expressed as

$$p = n1*P1 + n2*P2 + ... + nn*Pn$$

where:

$p$ = probability of a device to fail;
$Ni$ = number of defects generated between inspection level $i$ and inspection level $i-1$; and
$Pi$ = probability of a device to fail due to defects originated between the inspection level $i$ and inspection level $i-1$.

Each $Pi$ depends on the nature of the defects, and the size of the defects. $Pi$ is higher as the size of the defect increases. Dividing the defects by their size and grouping them into three different size intervals, for example, each $Pi$ can be separately computed. Therefore, the probability of a device failing can be expressed as:

$$P = n11*P11 + n12*P12 + n13*P13 + ... + nn1*Pn1 + nn2*pm2 + nn3*Pm3$$

where:

N11 is the number of defects generated between inspection level $i$ and inspection level $i-1$ belonging to defect size range 1; and
P11 is the probability of a device failing because of a defect having a defect size range of 1 originated between inspection level $i$ and inspection level $i-1$.

As will be appreciated by one skilled in the art, it is more straightforward and more accurate to predict if a memory array will fail the device than predicting any other failures in the device, such as input/output buffers connected to the memory array, for example.

From the start (Block **74**), a device **32a** within the processed wafer **30** is selected at Block **75**. At Block **76**, the number of detected defects and the probability of the device failing are initially set to 0. The inspection level $i$ and the defect size range $j$ are initially selected at Blocks **77** and **78**. The first inspection level $i$ may be selected and the smallest defect size range $j$ may be selected. At Block **80**, the detected defects at inspection level $i$ (not detected in previous inspections) with defect size range $j$ located within the memory array are counted (N+_ defects). This number is based on actual data from the device **32a** being processed.

If there are defects in the database of mapped defects associated with this inspection level $i$ and defect size range $j$ (Block **82**), then the probability $Pij$ of the detected defect causing a memory cell to fail is retrieved at Block **84**. This probability $Pij$ was stored in a database at Block **56** as illustrated in FIG. 3. The resulting probability P of the device to fail is determined by multiplying $Pij$ times the number of defects counted (N+_defects), and by taking into consideration (Pc) if there are multiple defects in the same memory area at Block **86**.

The remaining defect size ranges for the selected device **32a** are incremented at Block **88** so that other defects detected at inspection level $i$ are counted. Blocks **78-86** are repeated for the remaining defect size ranges. At Block **90**, the additional inspection levels $i$ are taken into consideration by repeating steps **76-86** for the defects detected at the next inspection level $i-1$.

Once all the inspection levels and size ranges have been examined, than the relationship $N = f(Pij, Nij)$ as determined at Block **92** is provided to the overall yield prediction algorithm at Block **94**. At Block **96**, a determination is made if there are more devices on the wafer that provided defect information which needs to be taken into consideration for the wafer yield prediction at Block **94**. If so, then steps **74-90** are repeated for the next device. For each device providing information, $N = f(Pij, Nij)$ is updated at Block **92**. This yield prediction algorithm is finished at Block **96**.

Another aspect of the invention relates to the apparatus **37** as shown in FIG. 2, which is for wafer yield prediction. The wafer yield prediction apparatus **37** includes a processor **39** for predicting failed memory cells in a device **32** on the wafer **30** based upon detected defects therein, and for predicting a yield of the wafer based upon the predicted failed memory cells so that the predicted yield can be compared to a threshold to determine if corrective action is needed.

The wafer yield prediction apparatus **37** further includes a memory **38** connected to the processor **39** for storing a database of mapped defect information. The database of mapped defect information is based upon a correlation of defects and associated failed memory cells. The processor **39** predicts failed memory cells by comparing detected defects to the database of mapped defect information.

The wafer yield prediction apparatus **37** may be part of the defect inspection device **36**, or a standalone apparatus as shown in FIG. 2. The memory cells are processed in successive layers, and the defect inspection device **36** inspects each layer. The database of mapped defect information is based upon size ranges of detected defects and the associated layer so that the failed memory cells are predicted by the processor **39** by initially determining a detected defect size range of each detected defect in an associated layer. The processor **39** predicts failed memory cells based upon matching the detected defect size range and associated layer with the database of mapped defect information.

The processor **39** is programmed to predict the yield by determining a number of detected defects within each size range and associated layer, and using the predicted failed memory cells and number of detected defects within each size range and associated layer to predict the yield. The memory cells form a random access memory, or may be part of an embedded memory, as readily appreciated by one skilled in the art.

## Claims

1.  A method for processing semiconductor wafers comprising:

    performing process steps to make at least one wafer comprising a plurality of devices with each device comprising an array of memory cells;
    inspecting each array of memory cells to detect defects;
    predicting failed memory cells based upon detected defects;
    predicting a yield of the at least one wafer based upon the predicted failed memory cells; and
    comparing the predicted yield to a threshold to determine if corrective action is needed.

2.  A method for processing semiconductor wafers comprising:

    performing process steps to make at least one wafer comprising a plurality of devices with each device comprising an array of memory cells;
    inspecting each array of memory cells to detect defects;
    predicting failed memory cells based upon detected defects by comparing detected defects to a database of mapped defect information, the database of mapped defect information being based upon a correlation of defects and associated failed memory cells; and
    predicting a yield of the at least one wafer based upon the predicted failed memory cells.

3.  A method according to claim 2 further comprising comparing the predicted yield to a threshold to determine if corrective action is needed.

4.  A method according to claim 2 or claim 3 further comprising creating the database of mapped defect information.

5.  A method according to claim 2 or claim 3 wherein performing the process steps comprises forming each array of memory cells in successive layers; and wherein inspecting comprises inspecting each layer.

6.  A method according to claim 5 wherein the database of mapped defect information is based upon size ranges of detected defects and the associated layer; and wherein predicting failed memory cells comprises:

    determining a detected defect size range of each detected defect in an associated layer; and
    predicting failed memory cells based upon matching the detected defect size range and associated layer with the database of mapped defect information.

7.  A method according to claim 6 wherein predicting the yield further comprises:

    determining a number of detected defects within each size range and associated layer; and

using the predicted failed memory cells and number of detected defects within each size range and associated layer to predict the yield.

8. A method according to claim 1 or claim 2 wherein each array of memory cells forms a random access memory.

9. A method according to claim 1 or claim 2 wherein each device comprises the array of memory cells as an embedded memory.

10. A method according to claim 1 or claim 2 wherein inspecting comprises optically inspecting.

11. A wafer yield prediction apparatus comprising:

a defect inspection device for detecting defects in a wafer comprising a plurality of devices with each device comprising an array of memory cells; and
a processor for predicting failed memory cells based upon detected defects, and for predicting a yield of the wafer based upon the predicted failed memory cells so that the predicted yield can be compared to a threshold to determine if corrective action is needed.

12. A wafer yield prediction apparatus according to Claim 11 further comprising a memory connected to said processor for storing a database of mapped defect information, the database of mapped defect information is based upon a correlation of defects and associated failed memory cells.

13. A wafer yield prediction apparatus according to Claim 12 wherein said processor predicts failed memory cells by comparing detected defects to the database of mapped defect information.

14. A wafer yield prediction apparatus according to Claim 11 wherein said defect inspection device optically inspects the memory cells.

15. A wafer yield prediction apparatus according to Claim 11 wherein the memory cells are processed in successive layers; and wherein said defect inspection device inspects each layer.

16. A wafer yield prediction apparatus according to Claim 15 wherein the database of mapped defect information is based upon size ranges of detected defects and the associated layer; and wherein predicting failed memory cells by said processor comprises:

determining a detected defect size range of each detected defect in an associated layer; and
predicting failed memory cells based upon matching the detected defect size range and associated layer with the database of mapped defect information.

17. A wafer yield prediction apparatus according to Claim 16 wherein said processor predicts the yield by:

determining a number of detected defects within each size range and associated layer; and
using the predicted failed memory cells and number of detected defects within each size range and associated layer to predict the yield.

*FIG. 1*

10 — ( START )

12 — PERFORMING PROCESS STEPS TO MAKE AT LEAST ONE WAFER COMPRISING A PLURALITY OF DEVICES

14 — INSPECTING EACH ARRAY OF MEMORY CELLS IN THE DEVICES TO DETECT DEFECTS

16 — PREDICTING FAILED MEMORY CELLS BASED UPON DETECTED DEFECTS

18 — PREDICTING A YIELD OF THE AT LEAST ONE WAFER BASED UPON THE PREDICTED FAILED MEMORY CELLS

COMPARING THE PREDICTED YIELD TO A THRESHOLD TO DETERMINE IF CORRECTIVE ACTION IS NEEDED — 20

( FINISH ) — 22

FIG. 2

PROCESSING CHAMBER – PROCESS STEP A
34
30
32a
32N

PROCESSING CHAMBER – PROCESS STEP B
34
30
32a
32N

DEFECT INSPECTION DEVICE
36

YIELD PREDICATION APPARATUS
37
PROCESSOR
39
MEMORY
38

*FIG. 3*

FIG. 4

## FIG. 5

73

START — 74

SELECT A DEVICE
WITHIN A WAFER — 75

SET N=0
AND P=0 — 76

SELECT INSPECTION
LEVEL i — 77

SELECT DEFECT
SIZE INTERVAL j — 78

COUNT DEFECTS
DETECTED AT
INSPECTION LEVEL
i WITH A DEFECT
SIZE RANGE j — 80

82 — IS THERE
ANY DEFECT
THAT SIZE ?

NO → MORE SIZE
RANGES ? — 88

YES

82 YES

GET Pij PREDICTION
FROM DATABASE — 84

86 — P−Pi+Pij*N+_Defects

MORE SIZE
RANGES ? YES →

MORE
INSPECTION
LEVELS ? — 90

YES

N=(P,Pij,Nij) — 92

MORE DEVICES ? — 96

YES

NO

YIELD = F(N) — 94

FINISH — 96